# EUROPÄISCHE PATENTSCHRIFT

(11) **EP 1 328 945 B1**
(45) Veröffentlichungstag und Bekanntmachung des Hinweises auf die Patenterteilung: **27.01.2010**
(21) Anmeldenummer: 01960146.7
(22) Anmeldetag: 03.08.2001
(51) Int. Cl.: G11C 27/02

(54) **STROM-ABTAST-HALTE-SCHALTUNG, ANALOG-DIGITAL-WANDLER UND VERFAHREN ZUM BETREIBEN EINER STROM-ABTAST-HALTE-SCHALTUNG**
CURRENT SAMPLE-AND-HOLD CIRCUIT, A/D CONVERTER AND A METHOD FOR OPERATING A CURRENT SAMPLE-AND-HOLD CIRCUIT
CIRCUIT ECHANTILLONNEUR BLOQUEUR DE COURANT, CONVERTISSEUR ANALOGIQUE/NUMERIQUE ET PROCEDE POUR EXPLOITER UN CIRCUIT ECHANTILLONNEUR BLOQUEUR DE COURANT

(30) Priorität: 04.08.2000 DE 10038231
(43) Veröffentlichungstag der Anmeldung: 23.07.2003
(73) Patentinhaber: Infineon Technologies AG, 81669 München (DE)
(72) Erfinder: PAULUS, Christian, 82362 Weilheim (DE)
(74) Vertreter: Viering, Jentschura & Partner
(86) Internationale Anmeldenummer: PCT/DE2001/002969
(87) Internationale Veröffentlichungsnummer: WO 2002/013200

(56) Entgegenhaltungen:
- EP-A- 0 412 609
- EP-A- 0 535 808
- US-A- 5 841 383

## Beschreibung

Die Erfindung betrifft eine Strom-Abtast-Halte-Schaltung mit mehreren Teilschaltungen, in denen ein Stromsignal gespeichert wird, wobei wenigstens eine der Teilschaltungen einen Schalter enthält, der auf einem konstanten Potential liegt.

Die Erfindung betrifft ferner einen Analog-Digital-Wandler mit wenigstens einer Strom-Abtast-Halte-Schaltung.

Die Erfindung betrifft außerdem ein Verfahren zum Betreiben einer Strom-Abtast-Halte-Schaltung.

Die Genauigkeit von Analog-Digital-Wandlern hängt unter anderem von den verwendeten Abtast-Halte-Schaltungen (Sample & Hold Circuits) ab, die ein analoges Eingangssignal zeitdiskret zu einer anschließenden Quantisierung bereitstellen.

Insbesondere bei Sample & Hold-Schaltungen in CMOS-Technik, deren Informationsübertragung in der Spannungsdomäne erfolgt, ist bekannt, dass zur Erzielung einer hohen Genauigkeit die relevanten Schaltelemente sich zu jedem Abschaltzeitpunkt auf einem virtuellen Massepotential befinden (Zero-Switching-Technik) sollen. Der Abschaltimpuls injiziert so stets die gleiche Fehlerladung in die Abtastkapazität, was vom Eingangssignal abhängige Abtastfehler vermeidet und in einer hohen Abtastgenauigkeit resultiert.

Werden statt Spannungen Ströme zur Informationsübertragung verwendet (current mode), so wird zumeist der Strom auf eine Spannung zurückgeführt, die in einem Kondensator gespeichert werden kann. Da der Kanal des Schalttransistors in den meisten Architekturen ein vom Eingangssignal abhängiges Potential aufweist, verfälscht die beim Abschaltvorgang injizierte Fehlerladung das Abtastergebnis. Durch Verwendung eines Operationsverstärkers kann auch hier eine Zero-switching Technik realisiert werden, was jedoch negative Auswirkungen auf die Bandbreite der Schaltung hat.

In US 5,841,383 wird eine Strom-Abtast-Halte-Schaltung nach dem Oberbegriff des Anspruchs 1 mit zur Speicherung des Stroms dienenden Teilschaltungen beschrieben, wobei der Fehler aufgrund der beim Abschaltvorgang injizierten Fehlerladung durch die Verwendung von Operationsverstärkern reduziert wird.

Eine gattungsgemäße Strom-Abtast-Halte-Schaltung ist aus dem Artikel Jonsson and S. Eriksson: "New Clock-Feedthrough Compensation Scheme for Switched-Current Circuits", Electr. Lett., Vol. 29, No. 16, pp. 1446-1447, Aug. 1993, bekannt. Diese Schaltung erfordert vier Teilschaltungen zur Speicherung des Signals.

Eine weitere gattungsgemäße Strom-Abtast-Halte-Schaltung ist aus dem Buch B. Jonsson et al., Switched-Current Circuits: From Building Blocks to Mixed Analog-Digital Systems, Stockholm 1999, S. 27-33, bekannt.

Der Einsatz von Schaltelementen, beispielsweise n-MOS-Transistoren, die sich zu jedem Zeitpunkt auf dem gleichen virtuellen Massepotential befinden, wird als Zero-Switching-Technik bezeichnet. Im Gegensatz zur Verwendung von Transmission-Gates, bestehend aus n- und p-MOS-Transistoren, ist hier der Haltezeitpunkt sehr exakt bestimmbar, da mit einem einzigen Signal alle Schalter gleichzeitig geöffnet werden, zumal sich alle Schalttransistoren stets auf gleichem konstanten Potential befinden. Insbesondere bei schnellen Analog-Digital-Wandlern (Analog Digital Converters - ADCs), wie sie beispielsweise zu einer Verarbeitung von Video-Signalen oder anderen hochfrequenten Signalen eingesetzt werden, bestimmt anderenfalls der jitter, also die Abweichungen des Abschaltzeitpunkts, wesentlich die Genauigkeit des Abtastgliedes. Ferner injiziert der Abschaltimpuls bei konstantem Schalterpotential stets die gleiche Fehlerladung in die Abtastkapazität, was vom Eingangssignal abhängige Abtastfehler vermeidet. Die Erfindung umfasst eine einfache Methode zur zeitdiskreten Stromsignalabtastung, bei der die relevanten Schaltelemente stets auf einem virtuellen Massepotential liegen und sich dadurch die oben genannten Vorteile (lowjitter, constant charge-inj ection) ergeben. Wegen ihrer geringen Komplexität eignet sie sich besonders für hohe Signalbandbreiten.

Um die signalabhängigen Abtastfehler, die nicht durch volldifferentielle Bauweise eliminiert werden können, zu reduzieren, werden verschiedene Maßnahmen ergriffen, die unter den Begriffen n-step-principle, Zero-Switching-Technik und Replica-Technik bekannt sind.

Ferner ist in US 5,227,676 eine Strom-Abtast-Halte-Schaltung mit einer zur Speicherung des Stroms dienenden Teilschaltung beschrieben. In der bekannten Strom-Abtast-Halte-Schaltung sind ferner lineare Widerstände vorgesehen, welche jedoch außerhalb der Teilschaltung angeordnet sind. Entsprechendes gilt für die in (B. Razavi, A 200-MHz 15-mW BiCMOS Sample-and-Hold Amplifier with 3 V Supply, IEEE Journal of Solid State Circuits, Vol. 30, No. 12, S. 1326 - 1332, December 1995) beschriebene Strom-Abtast-Halte-Schaltung.

Der Erfindung liegt die Aufgabe zugrunde, eine Strom-Abtast-Halte-Schaltung zu schaffen, bei der signalabhängige Abtastfehler möglichst weitgehend eliminiert werden.

Erfindungsgemäß wird diese Aufgabe mittels einer Strom-Abtast-Halte-Schaltung nach Anspruch 1.

Durch eine einfache Struktur der Schaltung und eine einfache Taktfolge der Signale sind nur wenige Abschaltimpulse, vorzugsweise nur ein einziger Abschaltimpuls notwendig. Hierdurch eignet sich die Strom-Abtast-Halte-Schaltung insbesondere auch für hochfrequente Anwendungen, beispielsweise für die Verarbeitung von Videosignalen.

Vorzugsweise beinhaltet die Erfindung einen voll differentiellen Aufbau der Schaltung. Durch einen differentiellen Aufbau ist es möglich, Fehler zu unterdrücken.

Gegenstand der Erfindung ist ferner, ein Verfahren zum Betreiben einer Strom-Abtast-Halte-Schaltung nach Anspruch 1.

Eine bevorzugte Ausführungsform der Strom-Abtast-Halte-Schaltung und des Verfahrens zu ihrem Betreiben zeichnet sich dadurch aus, dass die Strom-Abtast-Halte-Schaltung einen Verbindungsschalter aufweist, welcher derart angeordnet ist, dass wenigstens zwei Teilschaltungen über den Verbindungsschalter miteinander verbindbar sind.

Hierbei ist es besonders zweckmäßig, dass der Verbindungsschalter so angeordnet ist, dass in einem eingeschalteten Zustand des Verbindungsschalters ein Ladungsstrom von Speicherkondensatoren allein durch das Stromsignal erzeugt wird.

Ferner ist es vorteilhaft, die Strom-Abtast-Halte-Schaltung so zu gestalten, beziehungsweise das Verfahren zum Betreiben der Strom-Abtast-Halte-Schaltung so durchzuführen, dass alle Teilschaltungen Schalter enthalten, die auf jeweils gleichem Potenzial liegen.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Zeichnungen.

### Von den Zeichnungen zeigt:

- Fig. 1: ein Prinzipschaltbild einer Abtast-Halte-Schaltung für Spannungssignale,
- Fig. 2: ein Prinzipschaltbild einer erfindungsgemäßen volldifferentiellen Abtast-Halte-Schaltung und

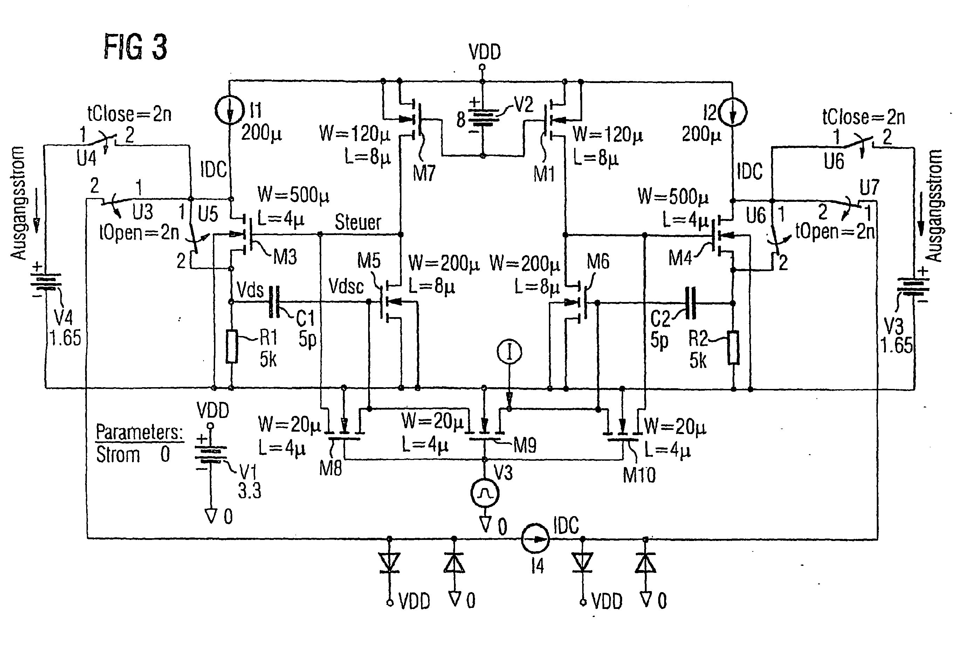

- Fig. 3: eine Detaildarstellung einer bevorzugten erfindungsgemäßen Schaltung.

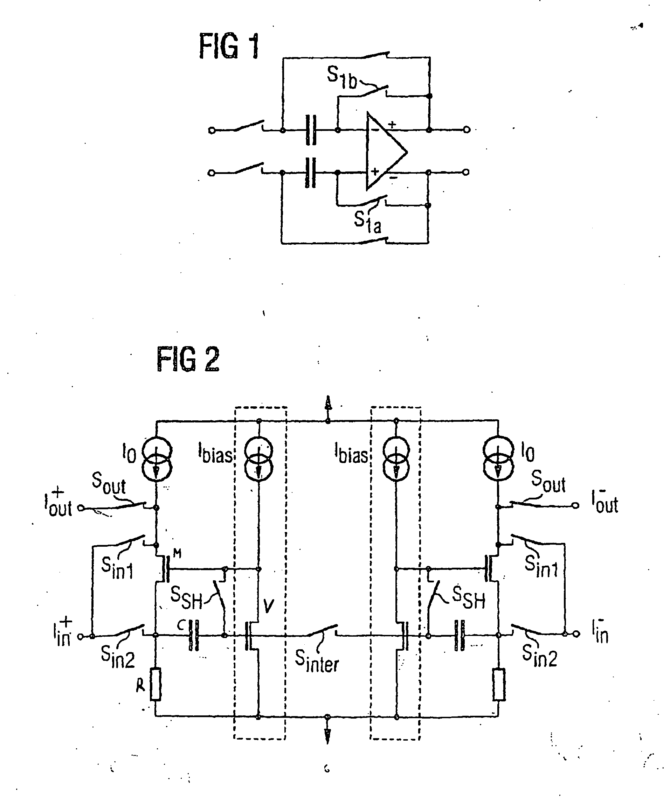

Fig. 1 zeigt eine Prinzipdarstellung einer Abtast-Halte-Schaltung für Spannungssignale mit Schaltern S₁ₐ und S_{1b}. Die die Genauigkeit bestimmenden Schalter S₁ₐ und S_{1b} liegen auf konstantem Potential und injizieren deshalb signalunabhängig die gleiche Fehlerladung.

Eine besonders zweckmäßige Ausführungsform.der Erfindung wird realisiert durch eine Strom-Abtast-Halte-Schaltung, bei der die Schaltelemente stets auf dem gleichen Potential liegen. Eine derartige Strom-Abtast-Halte-Schaltung ist beispielhaft in Fig. 2 dargestellt. Ein Eingangsstrom wird in einem Widerstand R linear in eine Spannung gewandelt. An einem Anschluss eines Schalttransistors S_{SH} befindet sich ein Kondensator C. Ist dieser Schalttransistor geöffnet, so entsteht durch den Speicherkondensator C, den Verstärker V und den Transistor M ein Regelkreis, der das Potential am Widerstand konstant hält. In dieser Form stellt die Schaltung eine Stromquelle mit hohem Ausgangswiderstand dar, die den abgetasteten Strom hält.

Vor dem Halten muss der Ladestrom des Kondensators C von dem kurzgeschlossenen invertierenden Verstärker V geliefert werden, was hohe Ströme erfordern kann. Bei einer volldifferentiellen Bauweise des Abtastgliedes wird dieser Verschiebestrom über den Schalter Sinter vom zweiten Zweig geliefert, so dass die Ausgangsstromanforderungen an die invertierenden Verstärker gering sind.

Der Verstärker V kann beispielsweise durch eine einfache Kaskodenschaltung realisiert werden, wodurch die Gesamtschaltung sehr hohe Bandbreiten zulässt.

Ein wichtiger Vorteil der Erfindung besteht darin, ein Strom-Abtast-Halte-Glied zu realisieren, bei dem die relevanten Schaltelemente auf einem festen Potential liegen, ohne komplizierte (= bandbreitebegrenzende) Operationsverstärkerstrukturen verwenden zu müssen. Durch den volldifferentiellen Aufbau lassen sich die Anforderungen an die Verstärkerschaltung V gering halten.

Vor dem Haltezeitpunkt wird der differentielle Eingangsstrom über die Widerstände nach Masse abgeleitet, was zu einer dem Strom proportionalen Spannung über dem Widerstand führt. Diese Spannung liegt an der einen Platte der Kondensatoren C an, die mit ihrem anderen Anschluss auf einem virtuellen Massepotential liegen, welches durch die von S_{SH} kurzgeschlossenen invertierenden Regelverstärker (gestrichelter Kasten) festgelegt wird.

### Zum Haltezeitpunkt werden gleichzeitig die Schalter S_{SH} und

Sinter geöffnet und anschließend die Eingangsschalter umgeschaltet. Der invertierende Regelverstärker hat nun die Aufgabe, einen Ausgangsstrom zu erzeugen, der einen Spannungsabfall über dem Widerstand in der ursprünglichen Höhe zur Folge hat. Um den geforderten Ausgangswiderstand der Stromquelle zu erreichen, muss die Regelschleife, bestehend aus dem Speicherkondensator C, dem invertierenden Verstärker und dem Regeltransistor über dem Widerstand, eine ausreichende Verstärkung aufweisen.

Der Schalter Sinter dient dazu, in der volldifferentiellen Ausführung der Schaltung den Ladestrom der Speicherkondensatoren alleine aus dem Signalstrom abzuleiten. Dadurch werden die Anforderungen an die invertierenden Regelverstärker reduziert, die anderenfalls den Ladestrom der Speicherkondensatoren abführen müssten.

Die Widerstände können auch eine nichtlineare Kennlinie aufweisen, zum Beispiel bei Ausführung als MOS-Transistoren im Triodengebiet. Dadurch kompensieren sich die Kapazitätsladeströme der beiden Signalzweige nicht mehr exakt, so dass der Differenzstrom von den kurzgeschlossenen Regelverstärkern geliefert werden muss.

Vorteilhaft bei dieser Lösung ist, dass die relevanten Schaltelemente zum Abschaltzeitpunkt stets das gleiche, konstante Potential aufweisen. Dadurch werden Abtastfehler, die aus jitter und charge-injection resultieren, wesentlich reduziert.

Durch die einfache Struktur und die einfache Taktfolge (ein einziger Abschaltimpuls) der Schaltung ist sie insbesondere für breitbandige Anwendungen geeignet, wobei die implementierte Zero-Switching-Technik gleichzeitig eine hohe Linearität ermöglicht.

### Bezugszeichenliste

- C: Kondensator
- M: Transistor
- R: Widerstand
- S₁ₐ: Schalter
- S_{1b}: Schalter
- Sᵢₙₜₑᵣ: Schalter
- S_{SH}: Schalttransistor
- V: Verstärker

## Patentansprüche

1. Strom-Abtast-Halte-Schaltung mit mehreren Teilschaltungen, in denen ein Stromsignal gespeichert wird, wobei wenigstens eine der Teilschaltungen einen Schalter (S_{SH}) enthält, wobei die Teilschaltungen jeweils wenigstens einen Widerstand enthalten, der so geschaltet ist, dass das Stromsignal an dem Widerstand (R) einen Spannungsabfall erzeugt, wobei die Teilschaltungen jeweils wenigstens einen invertierend betriebenen Regelverstärker (V) mit einem ersten Eingang, einem zweiten Eingang und einem Ausgang, einen Kondensator (C) zur Speicherung des Stromsignals und einen Regeltransistor (M) enthalten,
wobei der erste Eingang des Regelverstärkers (V) auf einem konstanten Potential liegt , der zweite Eingang des Regelverstärkers mit dem Kondensator elektriesh verbunden ist und der Ausgang des Regelverstärkers mit dem Gate des Regeltransistors (M) elektrisch verbunden ist, wobei in einer Halte-Betriebsart der Schalter (S_{SH}) geöffnet ist und durch den Kondensator (C), den invertierend betriebenen Regelverstärker (V) und den Regeltransistor (M) ein Regelkreis entsteht, der in der Halte-Betriebsart einen Ausgangsstrom der Schaltung einstellt, der einen Spannungsabfall über den Widerstand (R) zur Folge hat, der im Wesentlichen so groß ist wie der Spannungsabfall über den Widerstand (R) vor der Halte-Betriebsart, **dadurch gekennzeichnet, dass** der Schalter (S_{SH}) im eingeschalteten Zustand vor der Halte-Betriebsart den zweiten Eingang und den Ausgang des Regelverstärkers (V) kurzschließt, so dass das Potential des Schalters (S_{SH}) vor der Halte-Betriebsart konstant gehalten wird.

2. Strom-Abtast-Halte-Schaltung nach Anspruch 1, welche einen Verbindungsschalter (Sᵢₙₜₑᵣ) aufweist, welcher derart angeordnet ist, dass wenigstens zwei Teilschaltungen über den Verbindungsschalter (Sinter) miteinander verbindbar sind.

3. Strom-Abtast-Halte-Schaltung nach Anspruch 2,
wobei der Verbindungsschalter (Sinter) zwischen den Kondensatoren (C) der wenigstens zwei Teilschaltungen angeordnet ist, so dass in einem eingeschalteten Zustand des Verbindungsschalters (Sinter) ein Ladestrom der Speicherkondensatoren (C) allein durch das Stromsignal erzeugt wird.

4. Strom-Abtast-Halte-Schaltung nach einem oder mehreren der vorangegangenen Ansprüche, wobei alle Teilschaltungen Schalter enthalten, die auf jeweils gleichem Potential liegen.

5. Verfahren zum Betreiben einer Strom-Abtast-Halte-Schaltung nach einem oder mehreren der vorangegangenen Ansprüche.

## Claims

1. A current sample-and-hold circuit with several sub-circuits which store a current signal,
wherein at least one of the sub-circuits contains a switch (S_{SH}), wherein the sub-circuits each contain at least one resistor which is connected such that the current signal produces a voltage drop across the resistor (R), wherein the sub-circuits each comprise at least one inverting control amplifier (V), with a first input, a second input and an output, a capacitor (C) for storing the current signal and a control transistor (M),
wherein in a hold mode the switch (S_{SH}) is open and a control loop is formed with the capacitor (C), the inverting control amplifier (V) and the control transistor (M), which in the hold mode sets an output current for the circuit which causes a voltage drop across the resistor (R) which is essentially the same size as the voltage drop across the resistor (R) before the hold mode,
wherein the first input of the control amplifier (V) is set to a constant potential, the second input of the control amplifier is electrically connected to the capacitor, and the output of the control amplifier is electrically connected to the gate of the control transistor (M),
**characterized in that** the switch (S_{SH}) in the on-state prior to the hold mode short-circuits the second input and the output of the control amplifier (V) so as to keep the potential of the switch (S_{SH}) constant prior to the hold mode.

2. The current sample-and-hold circuit as claimed in claim 1,
comprising a connecting switch (Sᵢₙₜₑᵣ) which is arranged such that at least two sub-circuits can be connected to one another via the connecting switch (Sᵢₙₜₑᵣ),

3. The current sample-and-hold circuit as claimed in claim 2,
wherein the connecting switch (Sᵢₙₜₑᵣ) between the capacitors (C) of the at least two sub-circuits is arranged such that, in a turned-on state of the connecting switch (Sᵢₙₜₑᵣ), a charging current for storage capacitors (C) is produced solely by the current signal.

4. The current sample-and-hold circuit as claimed in one or more of the preceding claims,
wherein all sub-circuits comprise switches which are each at the same potential.

5. A method for operating a current sample-and-hold circuit as claimed in one or more of the preceding claims.

## Revendications

1. Circuit échantillonneur de courant comprenant plusieurs sous-circuits, dans lesquels un signal de courant est emmagasiné, au moins l'un des sous-circuits comportant un interrupteur (S_{SH}), les sous-circuits comportant respectivement au moins une résistance, qui est montée de façon à ce que le signal de courant produise une chute de tension aux bornes de la résistance (R), les sous-circuits comportant respectivement au moins un amplificateur (V) de régulation fonctionnant en inverseur, ayant une première entrée, une deuxième entrée et une sortie, un condensateur (C) d'emmagasinage du signal de courant et un transistor (M) de régulation, la première entrée de l'amplificateur (V) de régulation étant à un potentiel constant, la deuxième entrée de l'amplificateur de régulation étant reliée électriquement au condensateur et la sortie de l'amplificateur de régulation étant reliée électriquement à la grille du transistor (M) de régulation,
dans lequel, dans un type de fonctionnement en blocage, l'interrupteur (S_{SH}) est ouvert et il se crée, dans le condensateur (C), l'amplificateur (V) de régulation fonctionnant en inverseur et le transistor (M) de régulation, un circuit de régulation, qui établit, dans un type de fonctionnement en blocage, un courant de sortie du circuit, qui a pour conséquence une chute de tension aux bornes de la résistance (R), qui est sensiblement aussi grande que la chute de tension aux bornes de la résistance (R) avant le type de fonctionnement en blocage,
**caractérisé en ce que** l'interrupteur (S_{SH}) court-circuite à l'état fermé, avant le type de fonctionnement en blocage, la deuxième entrée et la sortie de l'amplificateur (V) de régulation, de sorte que le potentiel de l'interrupteur (S_{SH}) est maintenu constant avant le type de fonctionnement en blocage.

2. Circuit échantillonneur suivant la revendication 1,
qui a un interrupteur (Sᵢₙₜₑᵣ) de liaison, qui est monté de manière à ce qu'au moins deux sous-circuits puissent être reliés entre eux par l'interrupteur (Sᵢₙₜₑᵣ) de liaison.

3. Circuit échantillonneur suivant la revendication 2,
dans lequel l'interrupteur (Sᵢₙₜₑᵣ) de liaison est monté entre les condensateurs (C) d'au moins deux sous-circuits, de sorte que, dans un état fermé de l'interrupteur (Sinter) de liaison, un courant de charge des condensateurs (C) d'emmagasinage soit produit par le signal de courant à soi seul.

4. Circuit échantillonneur suivant l'une ou plusieurs des revendications précédentes,
dans lequel tous les sous-circuits comportent des interrupteurs, qui sont au même potentiel.

5. Procédé pour faire fonctionner un circuit échantillonneur de courant suivant l'une ou plusieurs des revendications précédentes.
